# EUROPEAN PATENT APPLICATION

(11) **EP 1 901 262 A1**
(43) Date of publication of application: **19.03.2008**
(21) Application number: 06756535.8
(22) Date of filing: 24.05.2006
(51) Int. Cl.: G09F 13/20

(54) **PHOSPHORESCENT MATERIAL, PROCESS FOR PRODUCING THE SAME, AND PHOSPHORESCENT DISPLAY ELEMENT**

(30) Priority: 30.06.2005 JP 2005193188
(71) Applicant: Japan Science and Technology Agency, Kawaguchi-shi, Saitama 332-0012 (JP)
(72) Inventor: YAMANAKA, Akio, Sapporo-shi, Hokkaido 063-0034 (JP); OKA, Kenji, 2990242 (JP); YOSHIDA, Norifumi, Okaya-shi, Nagano 394-0084 (JP); HORIUCHI, Hiroshi, Nasushiobara-shi, Tochigi 329-2756 (JP)
(74) Representative: Marshall, John Grahame
(86) International application number: PCT/JP2006/310329
(87) International publication number: WO 2007/004366

(57) **Abstract**

A novel phosphorescent material is provided which has a narrow afterglow spectrum width, a choosable afterglow wavelength, a high moisture resistance, a high thermal resistance, and no optical anisotropy.

It comprises a single crystal made of scandium oxide and a rare earth element substituting scandium of said single crystal, and generates the afterglow having a wavelength and spectrum width based on 4f-4f transition of the rare earth ion by irradiating ultraviolet light of the energy corresponding to the energy gap between 5d orbital of the rare earth ion and 2p orbital of oxygen of scandium oxide, or the energy gap between 4f excited orbital of the rare earth ion and 2p orbital of oxygen of scandium oxide. By choosing a rare earth element, the afterglow wavelength can be chosen. Since the host crystal is scandium oxide, it has the thermal resistance of 1000°C or higher. Since the crystal structure of scandium oxide is cubic, there is no double refraction.

## Description

### Technical Field

The present invention relates to a novel phosphorescent material that has a narrow afterglow spectrum width, can select an afterglow wavelength, has high moisture and thermal resistance, and is free from optical anisotropy, a process for producing the same, and a phosphorescent display device using said phosphorescent material.

### Background Art

The materials excited by absorbing energy and interaction with particles, electrons, or light resulting in light emission are called luminescent materials. The phenomenon in which light emission continues after excitation is terminated is called an afterglow phenomenon or phosphorescent phenomenon, and the materials causing an afterglow or phosphorescent phenomenon are called phosphorescent materials. Since phosphorescent materials emit light for a while after an excitation source disappears, they are used for white lines on roads, emergency exits of buildings for countermeasure against disaster, or for the guiding signs for escape, and also expected for application to various crafts or fibers.

As conventional phosphorescent materials, phosphorescent materials of aluminum complex oxide activated with rare earth element or others (See Patent References 1 - 7.), silicon oxide phosphorescent materials (See Patent Reference 8.), aluminum silicon complex oxide phosphorescent materials (See Patent Reference 9.), fluorine-containing aluminum complex oxides (See Patent Reference 10.), aluminum hydroxides (See Patent Reference 11.), and others are known. The sulfides such as zinc sulfide and cadmium sulfide have also been long known.
[Patent Reference 1] US Patent 329,466
[Patent Reference 2] US Patent 5,376,303
[Patent Reference 3] Chinese Patent Laid Open Application No. CN 1,053,807 A
[Patent Reference 4] Japanese Patent No. JP 2,543,825 B
[Patent Reference 5] Japanese Patent Laid Open Application No. JP H8-151574 A (1996)
[Patent Reference 6] Japanese Patent Laid Open Application No. JP 2000-63823 A
[Patent Reference 7] Japanese Patent Laid Open Application No. JP 2000-63825 A
[Patent Reference 8] Japanese Patent Laid Open Application No. JP H9-194833 A (1997)
[Patent Reference 9] Japanese Patent Laid Open Application No. JP H11-61116 A (1999)
[Patent Reference 10] Japanese Patent Laid Open Application No. JP 2001-131544 A
[Patent Reference 11] Japanese Patent Laid Open Application No. JP H11-302641 A (1999)
[Non-Patent Reference 1] G. Blasse and A.Bril, Philips Research Reports 22, 481 - 504 (1967)
[Non-Patent Reference 2] G. C. Aumuller, W. Kostler, B. C. Graaier, and R. Frey, Journal of Physics and Chemistry in Solid 55, 767-772 (1994)
[Non-Patent Reference 3] "Dictionary of Inorganic Compounds and Complexes" (in Japanese), Shogen Nakahara, Kodansha 1997
[Non-Patent Reference 4] "Making High Quality Phosphorescent Materials" Hikalo (in Japanese), Hiroaki Horiuchi, Kitakanto Sankangaku Kenkyukai, 13/1

### Disclosure of the Invention

### Problems to be Solved by the Invention

There are such problems here that the phosphorescent materials of aluminum complex oxides so far widely used can not select afterglow wavelength, and have broad afterglow spectrum widths, and for these reasons, a phosphorescent display devices using afterglow three primary colors have not realized, limiting the use of phosphorescent display devices. There are also such problems that the phosphorescent materials of aluminum complex oxides are low in moisture and thermal resistances, and therefore their life is short when used in the environment of high temperature and high moisture, limiting their uses. Since also the host crystal of the phosphorescent materials of aluminum complex oxides has a crystal structure belonging to an orthorhombic system, they have an optical anisotropy, causing double refraction. Therefore, for example, when such phosphorescent materials are used for a character display, the displayed characters are seen as double and not easy to read.
On the other hand, such sulfides as zinc sulfide and cadmium sulfide have long been used as light emitting and phosphorescent materials. Since sulfides have crystal structures belonging to a cubic system, they show no double refraction. However, it is known that many of sulfides tend to decompose when excited by ultraviolet light under high temperature and high moisture conditions, and the improvement of the moisture and thermal resistances of sulfides is essentially difficult. Also, the afterglow wavelength can be selected by making mixed crystals of sulfides, but there are such problems that increase of crystal defect by making mixed crystals is unavoidable, and that the afterglow time is short and the intensity is low.

Phosphorescent materials of aluminum complex oxides consist of strontium aluminate host crystals and rare earth elements doping to the host crystals. The rare earth elements doping in the host crystals substitute strontium, and exist in a form of bivalent ions in host crystals. The ground state of bivalent ionic rare earth elements in host crystals is 4f orbital, and the excited state is 5d orbital. The 5d orbital broadens energy level gap, due to its spatial shape, by influence of the surrounding crystal field, and changes the energy levels. Since the light emission is caused by electron transition between 4f orbital and the energy level gap-broadened 5d orbital, the light emitting spectrum width is broad, and hence the light emitting wavelength can not be changed widely enough though the kind of rare earth element is changed.
In order to obtain afterglow property, it is necessary to remove a ground state hole generated by an excited electron from the rare earth element, and delay the recombination of the excited electron and a hole (positive hole), which is conducted in case of the phosphorescent materials of aluminum complex oxides by doping a second rare earth element. That is, the hole generated by the electron excitation is trapped in the second rare earth element via the valence band of host crystals, and when the trapped hole returns to 4f orbital of the original rare earth element after a certain time elapsed, the light emission is caused by recombination of the electron excited to 5d orbital with the hole returned to 4f orbital, generating afterglow phenomenon.

For example, if europium (Eu) and dysprosium (Dy) are added as rare earth elements, europium exists as a bivalent ion (Eu²⁺) in a crystal, and electron transition is caused by photoexcitation from 4f to 5d orbital of Eu²⁺. The hole generated in 4f orbital of Eu²⁺ by said electron transition is trapped, via a valence band of an aluminate salt, in 4f orbital of Dy³⁺ present in the aluminate salt. Since an electron is in 5d orbital of Eu²⁺, a charge separation state is formed. The positive holes trapped in Dy return by a certain probability from this state to a valence band, and the excited state of Eu is caused again upon this returning, thus emitting light. The longer the charge separation state is maintained after a hole is trapped in Dy³⁺, the longer is the afterglow time. Since the stability of the charge separation state strongly depends upon the energy gap of 4f orbital of Dy³⁺ and the valence band of the aluminate salt, said energy gap has to be large in order for the afterglow time to be long, and in order for said energy gap to be large, the crystal structure of the aluminate salt has to be changed. In fact, if the ratio of n and m in strontium aluminate (SrO)ₙ(Al₂O₃)ₘ where n and m are positive integers, n/m is less than 1, then said energy gap becomes large, and the afterglow time becomes long. That is, phosphorescent property is improved.
However, as mentioned above, since the afterglow phenomenon of phosphorescent materials of aluminum complex oxides is caused between 4f orbital and the 5d orbital having a energy gap, the afterglow spectrum width is broad, and since the afterglow spectrum width is broad, the afterglow wavelength of high color purity corresponding to three primary colors can not be obtained.

Since strontium aluminate is a substance formed by combination of aluminum oxide Al₂O₃ with high melting point and excellent stability and strontium oxide SrO having low melting point and remarkably low moisture resistance, it is preferable not to use SrO in order to improve thermal and moisture resistances. However, the rare earth element to be added to obtain phosphorescence needs to exist by substituting atoms in host crystals, and for that purpose, strontium having a similar ion radius is indispensable. In order to improve thermal and moisture resistance of strontium aluminate, such additional treatment as fluorination is conducted (See Patent reference 10.), but thermal and moisture resistance has essential limitation so far as strontium oxide is used. In case to use Ca as a constituent element, since CaO is formed in a host crystal, thermal and moisture resistance is essentially low.

Since the host crystal of said phosphorescent material is aluminum oxide, it has a crystal structure belonging to a triclinic system, and causes double refraction due to optical anisotropy.

To wit, a light emitting material has so far been known which has a rare earth element doped in a scandium oxide (Sc₂O₃) sintered body (See Non-Patent references 1 and 2.), it is described that the light emitting body with terbium (Tb) doped in Sc₂O₃ and the light emitting body with praseodymium (Pr) doped in Sc₂O₃ have light emitting quantum efficiency of about 20%. Sc₂O₃ crystal has melting point of 2485°C, and is known to have a crystal structure of a cubic system (See Non-Patent reference 3.).
Since the rare earth atom in Sc₂O₃ exists as a trivalent ion, the number of electrons is less by one than the rare earth atom in aluminum complex oxide existing as a bivalent ion, and as a result, the energy level structure in case of a rare earth atom existing as a trivalent ion differs from the energy level structure in case of a rare earth atom existing as a bivalent ion, being an energy level structure capable of transition between f orbital of a ground state and f orbital of an excited state, that is, light emission due to f - f transition. Since f orbital is, compared with d orbital, less easily influenced by crystal field, and as a result, the range of energy level gap is narrow, light emission of narrow luminescence spectrum width is obtained, and since the change of energy level due to crystal field is small, the desired luminescence wavelength of narrow luminescence spectrum width can be obtained by changing a kind of rare earth element. Therefore, if the means to trap a hole in this luminescent material, for example, doping Dy like a aluminum complex oxide phosphorescent material is conducted, an afterglow wavelength of narrow afterglow spectrum width can be selected depending upon a kind of a rare earth element, and it is expected to obtain a phosphorescent material without double refraction and excellent in moisture and thermal resistances.

According to the above-mentioned expectation, the present inventors prepared the powder of Tb and Dy rare earth elements mixed into Sc₂O₃ feed powder, and the powder of Eu and Dy rare earth elements mixed into Sc₂O₃ feed powder, respectively, applied hydrostatic pressure of 300 MPa to these powder mixtures, respectively, to prepare respective feed rods, sintered these feed rods at 1600 °C for 36 hours in atmosphere, irradiated the obtained sintered material with ultraviolet light, and observed afterglow property. However, contrary to the above-mentioned expectation, though luminescence during ultraviolet irradiation could be observed, the visually detectable, that is, practically applicable afterglow property could not be observed.

However, the powder of Tb rare earth element mixed into Sc₂O₃ feed powder, the powder of Tb and Dy rare earth elements mixed into Sc₂O₃ feed powder, and the powder of Eu rare earth element mixed into Sc₂O₃ feed powder were prepared, respectively, hydrostatic pressure of 300 MPa was applied to these powder mixtures, respectively, to prepare respective feed rods, these feed rods were single crystalized using a floating zone crystal growth method. These single crystals were irradiated with ultraviolet light, then all of the single crystals showed an afterglow property which had the visually detectable, that is, practically applicable afterglow intensity, and had a narrow afterglow spectrum width and an afterglow time as long as 3 hours or more, resulting in the present invention.

As is understood from the explanation above, conventional phosphorescent materials have such a problem that an afterglow spectrum width is broad, an afterglow wavelength can not be selected, both moisture and thermal resistances are low, and they have optical anisotropy.
In view of the problems mentioned above, it is an object of the present invention to provide such a novel phosphorescent material that an afterglow spectrum width is narrow, an afterglow wavelength can be selected, moisture and thermal resistances are high, and it has no optical anisotropy, a process of producing the same, and a phosphorescent display device using said phosphorescent material.

### Means to Solve Problems

In order to attain the above-mentioned object, the phosphorescent material in accordance with the present invention is characterized to comprise single crystals of scandium oxide (Sc₂O₃) and a rare earth element substituting scandium in said single crystal, and, by irradiating ultraviolet light of energy lower than the band gap energy of a scandium oxide single crystal, generate the afterglow having a wavelength and a spectrum width based on f - f optical transition of a rare earth element.

According to the present invention, the afterglow property is caused by a hole generated by ultraviolet light irradiation being trapped in a single crystal lattice consisting of scandium oxide.

The irradiated ultraviolet light in case of terbium (Tb) as a rare earth element is the ultraviolet light of energy corresponding to the energy gap of 5d orbital and 4f ground orbital of terbium trivalent ion. The irradiated ultraviolet light in case of europium (Eu) as a rare earth element is the ultraviolet light of energy corresponding to the energy gap of 4f excited orbital of europium trivalent ion and 2p orbital of oxygen in a scandium oxide single crystal.

The phosphorescent material in accordance with the present invention has thermal resistance of 1000°C or higher, and since its crystal structure is cubic, double refraction is not caused.

A producing process of the phosphorescent material in accordance with the present invention is characterized to comprise a step to mix rare earth element powder into scandium oxide feed powder, a step to apply hydrostatic pressure to said powder mixture to prepare feed rods, and a step to single crystalize said feed rods using a floating zone crystal growth method.
According to said process, a phosphorescent material can be produced which consists of a single crystal of scandium oxide, and a rare earth element substituting scandium of said single crystal.

A phosphorescent display device in accordance with the present invention is characterized by using the phosphorescent material of the present invention.

### Effect of the Invention

With the phosphorescent material of the present invention, afterglow can be obtained which has narrow afterglow spectrum width and high color purity since it is based upon f - f optical transition. Since color purity is high, three primary color afterglow is possible by, for example, selecting a kind of rare earth element, and an afterglow display apparatus by three primary colors is possible.
Since the ultraviolet light to be irradiated is the ultraviolet light of energy lower than the band gap energy of a scandium oxide single crystal, sunlight may be the excitation light source. Since afterglow property is caused by a hole trapped in a single crystal lattice made of scandium oxide, afterglow time is extremely long. Since also thermal and moisture resistances are extremely high, afterglow display is highly visible because of high reliability as well as no double refraction caused.
By producing process in accordance with the present invention, the phosphorescent material of excellent property as mentioned above can be produced.
Since the afterglow display device in accordance with the present invention uses the phosphorescent material of excellent property as mentioned above, its color purity is high, the afterglow time is long, and the afterglow display is easily visible. Three primary colors afterglow display having a desired afterglow color is possible, if disposing respective phosphorescent materials in an appropriate ratio that generate the afterglow of three primary colors produced by selecting a kind of rare earth element.

### Brief Description of the Drawings

Fig. 1 illustrates the crystal structure of the phosphorescent material of the present invention;
Fig. 2 illustrates the afterglow mechanism of the phosphorescent material doped with a rare earth element Tb of the present invention, where a black circle ● indicates an electron and a white circle ○ indicates a hole;
Fig. 3 illustrates a floating zone crystal growth apparatus used to produce the phosphorescent material of the present invention;
Fig. 4 illustrates a luminescent spectrum of the phosphorescent material of the present invention;
Fig. 5 illustrates an excitation spectrum of the phosphorescent material of the present invention; and
Fig. 6 illustrates an afterglow property of the phosphorescent material of the present invention.

### Explanation of Marks and Symbols

1: Crystal Structure of Phosphorescent Material
2: Scandium
3: Rare Earth Element
4: Oxygen Simple Cubic Lattice
11: Floating Zone Crystal Growth Apparatus
12: Quartz Tube
13: Seed Rod
14: Feed Rod
15: Shaft
16: Rotary Ellipsoidal Mirror
17: Infrared Light Converging Heat Source
18: Infrared Light
19: Melting Part

### Best Modes for Carrying Out the Invention

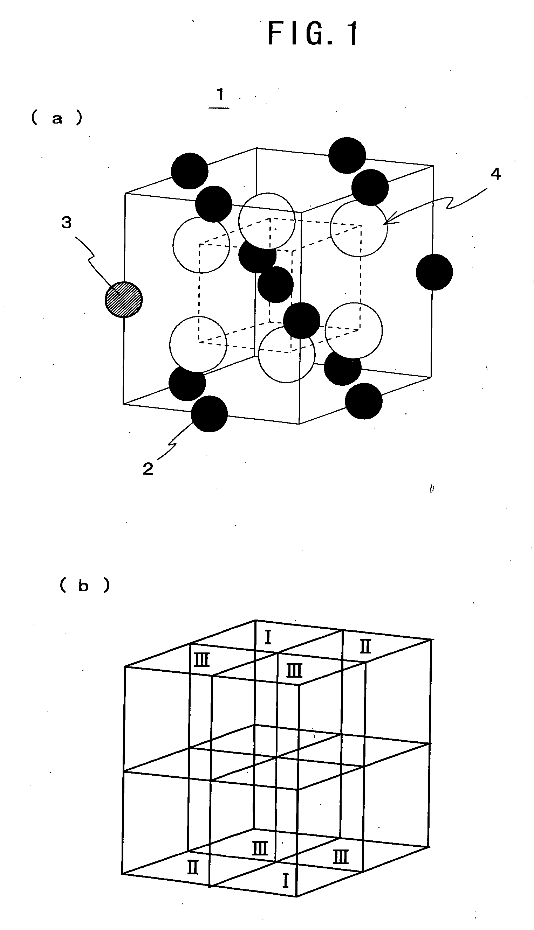

Hereinafter, the best modes of implementations of the present invention will be explained in detail.
First of all shown is the crystal structure of the phosphorescent material doped with a rare earth element of the present invention. Fig.1 illustrates the crystal structure of the phosphorescent material of the present invention where (a) indicates one of the three kinds of units constituting a basic unit lattice, and (b) indicates a basic unit lattice constituted with three kinds of assembling units. A large white circle ○ indicates oxygen (O), a black circle ● indicates scandium (Sc), and the slashed circle ○ indicates a rare earth element. Here, the three kinds of units are classified by disposition of an oxygen vacancy of an oxygen simple cubic lattice 4, having I, II, and III types.
As shown in Fig. 1(a), a phosphorescent material 1 of the present invention has the structure in which a part of scandium 2 in a scandium oxide (Sc₂O₃) single crystal is substituted with a rare earth element 3, and the rare earth element 3 exists at a lattice point as an ion of +3 valence. The rare earth element is preferably terbium (Tb) or europium (Eu).
As shown in Fig. 1(b), a phosphorescent material 1 of the present invention has the cubic crystal structure formed with a unit shown in Fig. 1(a) and similar two other kinds of units except for disposition of oxygen vacancies assembling together. Being a cubic crystal, double refraction is not caused.

The afterglow mechanism of the phosphorescent material of the present invention is explained below.

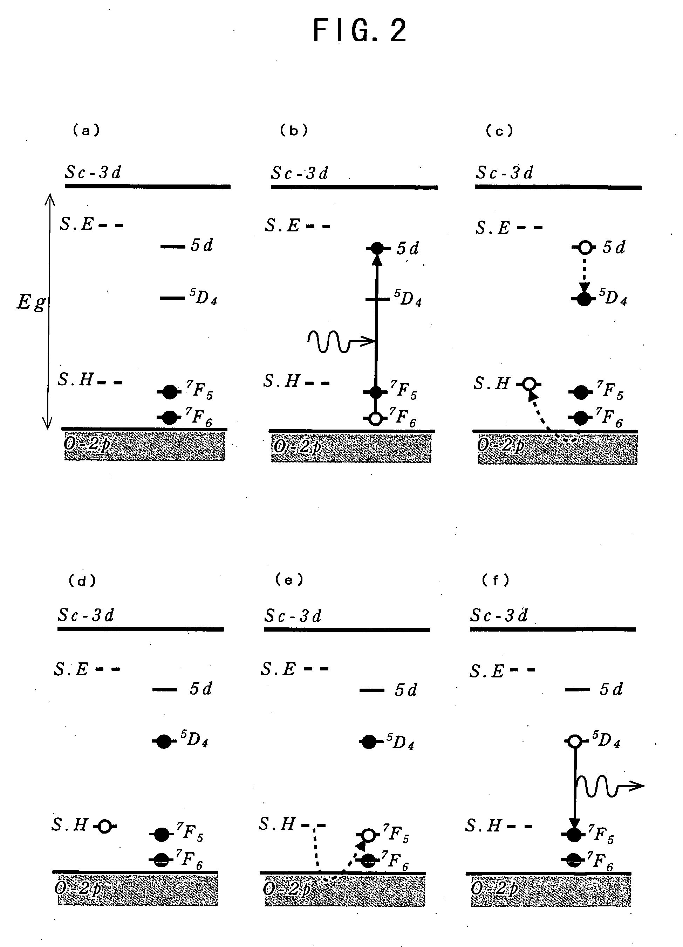

Fig. 2 illustrates the afterglow mechanism of the phosphorescent material doped with a rare earth element Tb of the present invention, where a black circle ● indicates an electron and a white circle ○ indicates a hole.
Fig. 2(a) illustrates an electron energy structure of the phosphorescent material doped with a rare earth element Tb of the present invention, where Sc - 3d indicates a conduction band of a Sc₂O₃ single crystal formed mainly from 3d orbital of Sc, O - 2p indicates a valence band of a Sc₂O₃ single crystal formed mainly from 2p orbital of O. The band gap energy Eg is about 6.3 eV (wavelength about 197 nm). Tb³⁺ ion has 8 4f electrons, and occupies 7 ground orbitals of 4f orbitals, but, among 7 ground orbitals, only the lowest ground orbital and the next lowest orbitals ⁷F₆ and ⁷F₅ levels are shown in the figure. Also as an excitation level, only the lowest excitation orbital ⁵D₄ level is shown among 4f excitation orbitals. As 5d, the level of 5d orbital having a principal quantum number larger by one than 4f orbital is shown. S.E indicates a level of a bound state of an electron (electron self-bound state) by an electron-lattice interaction between a scandium oxide single crystal lattice and an electron excited to a conduction band Sc - 3d, and S.H indicates a level of a bound state of a hole (hole self-bound state) by a hole-lattice interaction between a scandium oxide single crystal lattice and a hole excited to a valence band O - 2p. S.E level is located lower than the bottom of the conduction band Sc - 3d by about 1.3 eV to 1.4 eV, but higher than 5d level as shown in the figure. S.H level is located higher than the top of the valence band O - 2p by about 1.3 eV to 1.4 eV, and a little higher than ⁷F₅ level as shown in the figure.

Fig. 2(b) illustrates the case wherein the phosphorescent material doped with a rare earth element Tb of the present invention is irradiated with ultraviolet light of the energy corresponding to the energy gap of 5d and ⁷F₆ levels (wavelength 254 nm, 4.88 eV), and since the optical transition between 5d and ⁷F₆ levels has high transition probability, as illustrated, the electron of ⁷F₆ level absorbs ultraviolet light to transit to 5d level, resulting in hole formation in ⁷F₆ level.
Fig. 2(c) illustrates the state right after the electron of ⁷F₆ level transits to 5d level and a hole is formed in ⁷F₆ level, and the electron which transited to 5d level transits to ⁵D₄ level lower than S.E level by non-radiative transition, as well as the hole of ⁷F₆ level is thermally excited to transit without radiation to a valence band O - 2p, and a free hole which transited without radiation to a valence band O - 2p emits a phonon and is trapped in S.H level.
Since S.H level is formed by the interaction of a hole and a crystal lattice, if one hole is formed in a valence band O - 2p, then one S.H level is necessarily formed, and since a hole is trapped in this S.H level, quite many holes can be trapped compared with the conventional phosphorescent material the trap center of which such as impurity is doped.
Fig. 2(d) illustrates the state of the hole trapped in S.H level remaining quasi-stable.
Fig. 2(e) illustrates the state of the hole trapped in S.H level and thermally excited to transit without radiation to a valence band O - 2p, and a free hole which transited without radiation to a valence band O - 2p emitting a phonon and transiting to ⁷F₅ level.
Fig. 2(f) illustrates the state wherein, because of the transition of a hole to ⁷F₅ level, the excited state of a Tb³⁺ ion is generated again, and the electron excited to ⁵D₄ level recombines with a hole of ⁷F₅ level to emit light (wavelength 545 nm, 2.3 eV). The thermal excitation of a hole in S.H level to a valence band O - 2p occurs extremely slowly because the energy gap between the valence band O - 2p and S.H level is large, as illustrated, and since quite many holes are trapped in S.H level, as explained in Fig.2(c), remarkable afterglow occurs.
As is understood from explanation of Fig. 2(a) - Fig. 2(f) above, the phosphorescent material doped with a rare earth element Tb of the present invention generates afterglow having a wavelength and a spectrum width based on f - f optical transition of the rare earth element by irradiating ultraviolet light of the energy lower than the band gap energy of a scandium oxide single crystal. Since the influence of a ligand field on an f electron is small compared with that on a d electron, the spectrum width is narrow. Since the afterglow property is generated that the holes formed by ultraviolet light irradiation are being trapped to holes to lattice interaction with a single crystal lattice made of scandium oxide, then the afterglow time is extremely long.
Here, in order to make explanation above simple and brief, only typical ground or excited level is explained, and also the explanation is skipped for an expansion of spectrum width due to the ligand field or phonons.

The afterglow mechanism of a phosphrescent material doped with a rare earth element Eu is explained next.
Since 4f electrons of an Eu³⁺ ion are six, and the orbital of the highest energy among the seven 4f ground orbitals is unoccupied, the energy required to excite an electron in 2p orbital of oxygen to the excited orbital of Eu³⁺ ion, that is, CT energy (charge transfer energy) is small, and the excited energy from 4f to 5d orbital of Eu³⁺ ion is large. Therefore, CT energy is smaller than the excited energy from 4f to 5d orbital, and if ultraviolet light of the energy corresponding to CT energy (wavelength 254 nm, 4.88 eV) is irradiated, the electron of 2p orbital of oxygen is excited to the excited level of Eu³⁺ ion, and a hole is formed in a valence band O - 2p. Said holes are trapped in S.H level as in (c) and (d) of Fig. 2, and since the holes trapped in S.H level returns over a long period of time to 4f ground level of Eu³⁺ ion as in (e) and (f) of Fig. 2 to recombine with the electrons of 4f excited level, the remarkable long afterglow is generated.

Explanation is made of electron - lattice interaction by d - p hybrid orbital and hole - lattice interaction.
An electron - lattice interaction is the interaction between an electron and a lattice via the charge of an electron and the charge of an ion present at a lattice point, and an electron acts while distorting the lattice. When the strength of said interaction becomes large exceeding a certain limit, the electron is bound in the lattice distortion which it made up by itself and becomes unmovable. A hole - lattice interaction is likewise.
It has become apparent recently from the first principle calculation that, in metal oxides, particularly in transition metal oxides, d orbital of a transition metal and 2p orbital of oxygen are hybridized to a fair extent. In such d - p hybrid orbital, interaction of an electron or a hole and a crystal lattice is extremely large, and when a hole is introduced into the hybrid orbital, an oxygen ion is largely displaced. If the hole introduced into d - p hybrid orbital propagates in a lattice, it is necessarily accompanied by the oxygen ion displacement, and hence the hole can not propagate, being localized at an oxygen site or its vicinity. Considering on an energy term, in order for a trapped hole to move, it is trapped because unmovable unless energy is obtained which corresponds to the increase of lattice elastic energy by the oxygen ion displacement.
For utilizing this phenomenon for phosphorescent mechanism, first of all, a host crystal must have a transition metal atom having d electron in an outermost shell as a crystal constituting element in order to utilize the optical transition allowable f - d transition of a rare earth ion for photoexcitation. Secondly, since a rare earth atom as a luminescence center must exist with said transition metal atom to be substituted, the ion radius of said transition metal atom needs to be about same as the ion radius of the rare earth atom as a luminescence center. Thirdly, in order to utilize the optical transition allowable f - d transition of a rare earth ion for photoexcitation, the transparency is required at least to 250 nm of wavelength. The scandium oxide host crystal of the present invention is a crystal fulfilling all three conditions above.

Even with a host crystal fulfilling such conditions, perfection of a host crystal is quite important to cause hole - lattice interaction. For example, if crystal dislocations exist in a host crystal, then since an oxygen ion can not be displaced, or loses a function as a lattice elastomer, a hole can no longer be trapped, and the afterglow property is no longer generated. Also, if the crystal grain boundaries exist, then since many defects exist near the crystal grain boundaries, holes trapped in said defect are more stable energetically, and hence are trapped near the crystal grain boundaries, not introduced into d - p hybrid orbital. On the other hand, an photo-excited electron present in the excited orbital is more stable energetically if trapped in defects near the crystal grain boundaries, and as a result, both electrons and holes move away from a rare earth ion as luminescence centers, and recombine without contributing light emission via a non-radiative transition process by dispersion with defects and impurities without contributing light emission.
The reason why the afterglow property was not generated by a poly-crystal material formed by sintering is that, as described above, it is considered as due to crystal defects such as crystal dislocations and crystal grain boundaries. On the other hand, since the phosphorescent material of the present invention has a single crystal as a host crystal, it has no crystal grain boundaries or crystal dislocations, and it is considered that, as a result, a hole - lattice interaction is caused to trap holes, and the afterglow property is generated.

### Explanation is made below of a floating zone crystal growth apparatus used to produce the phosphorescent material of the present invention.

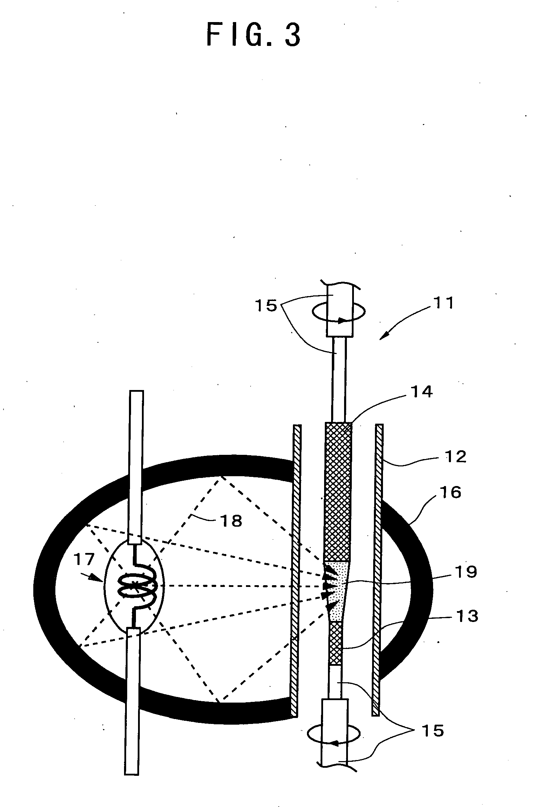

Fig. 3 illustrates a floating zone crystal growth apparatus used to produce the phosphorescent material of the present invention. The floating zone crystal growth apparatus 11 is provided with a quartz tube 12 for introducing either or both of argon or oxygen from a gas supplying system such as a not illustrated gas cylinder to maintain a pre-determined gas atmosphere, shafts 15 and 15, movable rotary and up and down, holding a seed rod 13 below and a feed rod 14 above inside said quartz tube 12, a rotary ellipsoidal mirror 16 having bifocus, an infrared light converging heat source 17 such as a xenon lamp set at one of the focal positions, and a not illustrated window for observation, and rotation and up and down movement of the shafts 15 and 15, heating temperature, and temperature rising and lowering rate are controlled by a not illustrated computer. Furthermore, a tip of a seed rod 13 held by one of the shafts 15 and a tip of a feed rod 14 held by the other shaft 15 are provided at the other focal position of the rotary ellipsoidal mirror 16, and the pre-determined growth rate is set and maintained by controlling the up and down movement of the shafts 15 and 15. Here in the figure, numeral 18 indicates infrared light converged at the other focal position of the rotary ellipsoidal mirror 16.
In such a floating zone crystal growth apparatus 11, if both tips of the held seed rod 13 and the feed rod 14 are heated, melted, and contacted, and then a melting part 19 is formed, the shafts 15 and 15 are slowly moved downward, and a melting zone is gradually moved toward the feed rod, then a single crystal grows at the seed rod side.
Hereafter, more explanation is made referring to several Examples.

### [Example 1]

### Explanation is first made of an example of producing a scandium oxide (Sc₂O₃) single crystal.

A feed rod was produced by packing Sc₂O₃ powder (purity 99.9%) into a rubber balloon having about 6mm in diameter and about 25 cm length for balloon art, and applying hydrostatic pressure of 300MPa by a piston cylinder type hydrostatic pressure generator. Said feed rod was inserted into an electric furnace and sintered at about 600°C in atmosphere. Using sintered feed rod, the cylindrical single crystal having 2.9 mm diameter and 30 mm length was produced by floating zone crystal growth apparatus as shown in Fig. 1. The feed rod began melting at a xenon lamp current 73.65A (ampere), and the electric current upon single crystal growth was controlled at 84.5 A to 87.6 A. The crystal growth rate was 10 to 20 mm/hour. In a quartz tube 2, argon gas of atmospheric pressure was recycled at 0.5 liter per minute. Here, the melting temperature and the temperature during crystal growth were as high as over 2000°C, so that there was no thermometer available which could contact a melting zone. Since a radiation thermometer could neither be used because of infrared light background by a xenon lamp, these temperatures could not be measured, and hence these temperatures are not shown.
Upon irradiation of ultraviolet light of wavelength 254 nm to said single crystal, the intense luminescence of yellowish green color was observed. When the ultraviolet light irradiation was terminated, the luminescence still lasted, and thus the afterglow was confirmed visually.

### [Example 2]

### Explanation is made of an example of producing Sc₂O₃ single crystal doped with terbium (Tb) by 0.1% (mole%).

13.7769g of Sc₂O₃ powder (purity 99.9%) and 0.0411g of terbium acetate dihydrate (CH₂COOH)₃Tb·H₂O powder (purity 99.9%) were weighed so that Tb concentration became 0.1%. Sc₂O₃ powder and (CH₂COOH)₃Tb·H₂O powder were input into a mortar, 30 ml of ion exchanged water was added, and then well mixed, and this mixture was dried in a 40°C oven drier. For decomposing acetic acid, said mixture was input into an electric furnace and sintered at about 600°C in atmosphere. Said sintered material was mixed again using a mortar, a feed rod was produced by the similar method to Example 1, and from said feed rod was produced a cylindrical single crystal of 4.31 mm diameter and 26.14 mm length. The feed rod began melting at a xenon lamp current about 81A, and the electric current upon single crystal growth was 82.2 A to 89.80 A. The atmospheric gas upon crystal production was same as in Example 1. Upon irradiation of ultraviolet light of wavelength 254 nm to said single crystal, the intense luminescence of yellowish green color was observed. When the ultraviolet light irradiation was terminated, the luminescence still lasted, and thus the afterglow was confirmed visually.

### [Example 3]

### Explanation is made of an example of producing a Sc₂O₃ single crystal doped with Tb by 0.3%.

13.3771g of Sc₂O₃ powder (purity 99.9%) and 0.1234g of terbium acetate dihydrate (CH₂COOH)₃Tb·H₂O powder (purity 99.9%) were weighed so that Tb concentration became 0.3%. The cylindrical single crystal of 2.67 mm diameter and 18.92 mm length was produced by similar feed producing and crystal growth methods same as in Example 1. The feed rod began melting at a xenon lamp current 91.61A, and the electric current upon single crystal production was 90.63 A to 94.17 A. The atmospheric gas upon crystal production was same as in Example 1. Upon irradiation of ultraviolet light of wavelength 254 nm to the sample, the intense luminescence of yellowish green color was observed. When the ultraviolet light irradiation was terminated, the luminescence still lasted, and thus the afterglow was confirmed visually.

### [Example 4]

### Explanation is made of an example of producing a Sc₂O₃ single crystal doped with Tb by 1.0%.

12.4118g of Sc₂O₃ powder (purity 99.9%) and 0.1867g of terbium oxide (Tb₄O₇) powder (purity 99.99%) were weighed so that Tb concentration became 1.0%, mixed in a mortar, and a cylindrical single crystal of 3.86 mm diameter and 54.61 mm length was produced by similar feed producing and crystal growth methods same as in Example 1. The feed rod began melting at a xenon lamp current 83.79A, and the electric current upon single crystal growth was 81.20 A to 96.62 A. The atmospheric gas upon crystal growth was same as in Example 1. Upon irradiation of ultraviolet light of wavelength 254 nm to the sample, the intense luminescence of yellowish green color was observed. When the ultraviolet light irradiation was terminated, the luminescence still lasted, and thus the afterglow was confirmed visually.

### [Example 5]

### Explanation is made of an example of producing a Sc₂O₃ single crystal doped with Tb by 3.0%.

13.3772g of Sc₂O₃ powder (purity 99.9%) and 0.5609g of Tb₄O₇ powder (purity 99.99%) were weighed so that Tb concentration became 3.0%, mixed in a mortar, and a cylindrical single crystal of 3.44 mm diameter and 17.87 mm length was produced by similar feed producing and crystal growth methods same as in Example 1. The feed rod began melting at a xenon lamp current 83.38A, and the electric current upon single crystal growth was 82.38 A to 85.46 A. The atmospheric gas upon crystal production was same as in Example 1. Upon irradiation of ultraviolet light of wavelength 254 nm to the sample, the intense luminescence of yellowish green color was observed. When the ultraviolet light irradiation was terminated, the luminescence still lasted, and thus the afterglow was confirmed visually.

### [Example 6]

### Explanation is made of an example of producing a Sc₂O₃ single crystal doped with Tb by 0.5% and dysprosium (Dy) by 0.05%.

Sc₂O₃ powder (purity 99.9%), Tb₄O₇ powder, and dysprosium oxide powder (purity 99.9%) were weighed so that Tb concentration became 0.5% and Dy concentration 0.05%, mixed in a mortar, and the cylindrical single crystal of about 4 mm diameter and about 17 mm length was produced by similar feed producing and crystal growth methods as same in Example 1. The feed rod began melting at a xenon lamp current 79.80A, and the electric current upon single crystal growth was 95.00 A to 99.61 A. An oxygen gas of atmospheric pressure of 0.5 liter per minute was recycled in the quartz tube 2. Upon irradiation of ultraviolet light of wavelength 254 nm to the sample, the intense luminescence of yellowish green color was observed. When the ultraviolet light irradiation was terminated, the luminescence still lasted, and thus the afterglow was confirmed visually.

### [Example 7]

### Explanation is made of an example of producing a Sc₂O₃ single crystal doped with europium (Eu) by 0.1%.

13.7769g of Sc₂O₃ powder (purity 99.9%) and 0.0176g of europium oxide (Eu₂O₃) powder (purity 99.9%) were weighed so that Eu concentration became 0.1%, mixed in a mortar, and the cylindrical single crystal of 4.12 mm diameter and 8.62 mm length was produced by similar feed producing and crystal growth methods same as in Example 1. The feed rod began melting at a xenon lamp current 91.79A, and the electric current upon single crystal growth was 87.82 A to 90.90 A. The atmospheric gas upon crystal growth was same as in Example 1. Upon irradiation of ultraviolet light of wavelength 254 nm, the intense luminescence of orange color was observed. When the ultraviolet light irradiation was terminated, the luminescence still lasted, and thus the afterglow was confirmed visually.

### [Example 8]

### Explanation is made of an example of producing a Sc₂O₃ single crystal doped with Eu by 0.3%.

13.7486g of Sc₂O₃ powder (purity 99.9%) and 0.1056g of Eu₂O₃ powder (purity 99.9%) were weighed so that Eu concentration became 0.3%, mixed in a mortar, and the cylindrical single crystal of 4.0 mm diameter and 31.8 mm length was produced by similar feed producing and crystal growth methods same as in Example 1. The feed rod began melting at a xenon lamp current 85.03A, and the electric current upon single crystal growth was 91.44 A to 97.59 A. The atmospheric gas upon crystal growth was same as in Example 1. Upon irradiation of ultraviolet light of wavelength 254 nm, the intense luminescence of orange color was observed. When the ultraviolet light irradiation was terminated, the luminescence still lasted, and thus the afterglow was confirmed visually.

### [Example 9]

### Explanation is made of an example of producing a Sc₂O₃ single crystal doped with Eu by 1.0%.

13.7769g of Sc₂O₃ powder (purity 99.9%) and 0.0176g of Eu₂O₃ powder (purity 99.9%) were weighed so that Eu concentration became 1.0%, mixed in a mortar, and the cylindrical single crystal of 4.12 mm diameter and 8.62 mm length was produced by similar feed producing and crystal growth methods same as in Example 1. The feed rod began melting at a xenon lamp current 91.79A, and the electric current upon single crystal growth was 87.82 A to 90.90 A. The atmospheric gas upon crystal growth was same as in Example 1. Upon irradiation of ultraviolet light of wavelength 254 nm, the intense luminescence of orange color was observed. When the ultraviolet light irradiation was terminated, the luminescence still lasted, and thus the afterglow was confirmed visually.

### [Example 10]

The luminescent spectra of phosphorescent materials of the present invention are shown below.

The cylindrical single crystals obtained in Examples 1-9 were cut by a precise low speed cutter (IsoMet of U.S. Buehler, diamond cutting blade 15HC), and disc-shaped samples of about 2 mm thickness were produced. The luminescent and excitation spectra of these samples were measured by a fluorescent spectrometer (Hitachi F-4500) in atmosphere at room temperature. The ultraviolet light of wavelength 254 nm was used as excitation light. The ultraviolet light of wavelength 254 nm has the energy approximately corresponding to the energy gap between 5d orbital of Tb³⁺ and 4f ground orbital of Tb³⁺ and the energy gap between 4f excitation orbital of Eu³⁺ and 2p orbital of oxygen of scandium oxide. Here, the band gap energy of Sc₂O₃ single crystal is 6.3 eV (wavelength 197 nm).

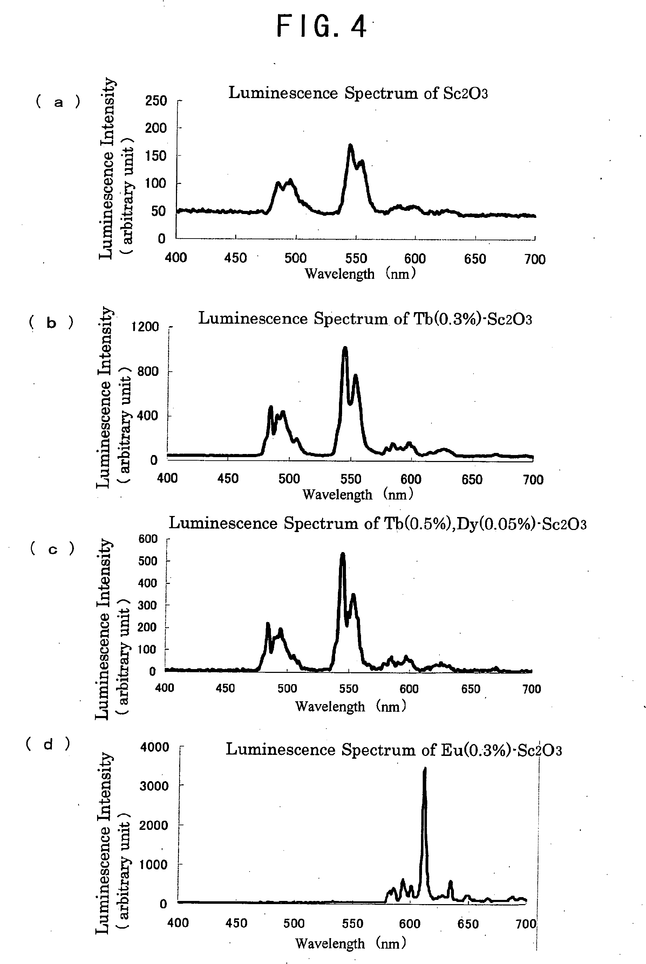

Fig. 4 illustrates a luminescent spectrum of the phosphorescent material of the present invention, wherein (a) is a luminescent spectrum of Sc₂O₃ single crystal produced in Example 1, (b) is a luminescent spectrum of Sc₂O₃ single crystal doped with Tb by 0.3% produced in Example 3, (c) is a luminescent spectrum. of Sc₂O₃ single crystal doped with Tb by 0.5% and Dy by 0.05% produced in Example 6, and (d) is a luminescent spectrum of Sc₂O₃ single crystal doped with Eu (0.3%) produced in Example 8.
It is seen from Fig. 4 that all of the luminescent spectra of (a), (b), and (c) have peaks at 475 and 545 nm, and have narrow spectrum widths of about 20 nm. These peak wavelengths agree with the luminescent wavelength based on f - f transition of Tb³⁺, and it is seen that these luminescences are based on f - f transition of Tb³⁺ because the spectrum width is narrow. As is shown in Fig. 4(a), the fact that Sc₂O₃ single crystal not doped with a rare earth element shows a similar luminescent spectrum implies to be caused by Tb contained by trace amount (0.1% or less) in Sc₂O₃ feed powder.
It is seen from Fig. 4 that the luminescent spectrum of (c) wherein Dy was doped in addition to Tb is not changed at all from those of (a) and (b). From this fact, it is seen that Dy does not contribute to luminescence. The luminescent spectrum of (d) is seen to comprise a plurality of luminescent spectra of narrow spectrum width from 580 nm to 650 nm. These spectra agree with the luminescent wavelength based on f - f transition of Eu³⁺, and it is seen that these luminescences are based on f - f transition of Eu³⁺ because the spectrum width is narrow.

### [Example 11]

### The excitation spectra of phosphorescent materials of the present invention are shown.

While changing the excitation light wavelength maintaining the excitation light intensity at constant, the luminescent intensity at each wavelength was measured by the fluorescent spectrometer. As the luminescent peaks used for luminescent intensity measurement, the peaks which have the strongest luminescent intensities of respective samples were chosen, that is, the peaks of 545 nm for the sample doped with Tb and 611 nm for the sample doped with Eu were chosen.

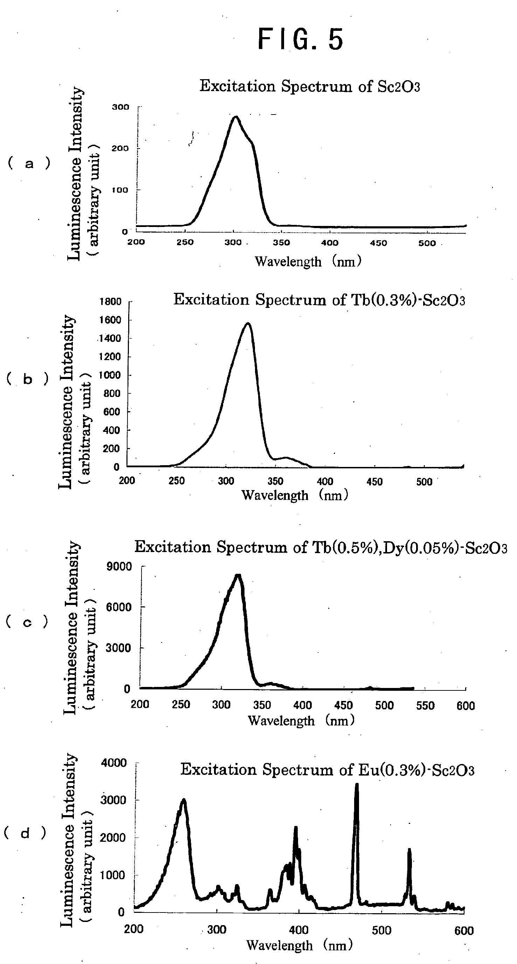

Fig. 5 illustrates an excitation spectrum of the phosphorescent material of the present invention, wherein (a) is an excitation spectrum of Sc₂O₃ single crystal produced in Example 1, (b) is an excitation spectrum of Sc₂O₃ single crystal doped with Tb by 0.3% produced in Example 3, (c) is an excitation spectrum of Sc₂O₃ single crystal doped with Tb by 0.5% and Dy by 0.05% produced in Example 6, and (d) is an excitation spectrum of Sc₂O₃ single crystal doped with Eu (0.3%) produced in Example 8.
It is seen from Fig. 5 that the excitation spectra of (a), (b), and (c) have peaks near wavelength 300 nm, and have the broad spectrum widths of about 100 nm. The wavelength 290 nm involved in said peak corresponds to the energy gap between 5d orbital and 4f ground orbital of Tb³⁺, and since the spectrum width is broad, it is seen that the luminescence of the phosphorescent material doped with Tb of the present invention is based on an electron photo-excited from 4f ground orbital of Tb³⁺ to 5d orbital the level width of which is broadened by influence of crystal field. As explained above, since the luminescent spectra of (a), (b), and (c) are based on f - f transition of Tb³⁺, it is seen that the electron photo-excited to 5d orbital transits to 4f excited orbital of Tb³⁺ by non-radiative transition, and emits light upon transition from 4f excited orbital of Tb³⁺ to the ground orbital of Tb³⁺.
Since the excitation spectrum of (a) is equivalent to the excitation spectra of (b) and (c), it is seen that the luminescence of Sc₂O₃ is caused by Tb impurity contained in a trace amount in Sc₂O₃ feed material. It is also seen from (d) that the excitation spectrum of the phosphorescent material doped with Eu of the present invention has a peak near wavelength 250 nm, and has relatively narrow spectrum width of about 30 nm. The wavelength 250 nm corresponds to the CT energy gap between 4f excited orbital of Eu³⁺ and 2p orbital of oxygen of Sc₂O₃, and since the spectrum width is narrow compared with that of 4f - 5d transition. It is considered that the luminescence of the phosphorescent material doped with Eu of the present invention is caused by electron directly photo-excited from 2p orbital of oxygen of Sc₂O₃ to 4f excited orbital of Eu³⁺.

### [Example 12]

### The afterglow property of phosphorescent materials of the present invention is shown.

The ultraviolet light of wavelength 254 nm was irradiated for 5 minutes by the intensity of about 0.7 m W/cm², and the afterglow intensity from right after termination of irradiation was measured as the function of the elapsed time. The afterglow time is defined as the elapsed time until the afterglow intensity right after termination of the excitation light irradiation decreases by 1/10 (See Non-Patent Reference 4.).

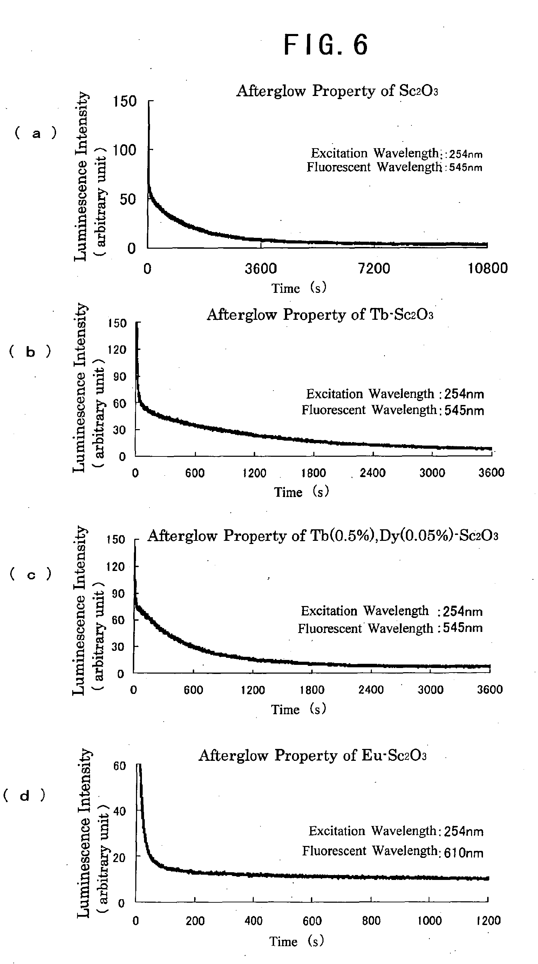

Fig. 6 illustrates an afterglow property of the phosphorescent material of the present invention, wherein (a) is the afterglow property of Sc₂O₃ single crystal produced in Example 1, (b) is the afterglow property of Sc₂O₃ single crystal doped with Tb by 0.3% produced in Example 3, (c) is the afterglow property of Sc₂O₃ single crystal doped with Tb by 0.5% and Dy by 0.05% produced in Example 6, and (d) is the afterglow property of Sc₂O₃ single crystal doped with Eu (0.3%) produced in Example 8. Since the luminescence intensity at time 0 in each figure is the luminescence intensity during excitation light irradiation, that is, the luminescence intensity when both fluorescence and the afterglow are simultaneously present, 1/e of the luminescence intensity at time 0 was used as the afterglow intensity right after termination of excitation light irradiation, that is, as the afterglow initial value for measurement of afterglow time.
It is seen from Fig. 6 that the Sc₂O₃ single crystals doped with either Tb or Eu both have quite long afterglow time of 3 hours or even longer. Since the Sc₂O₃ poly-crystal material doped with either Tb or Eu produced by sintering using the same feed material has no afterglow property, as described above, it is seen that the afterglow property of phosphorescent materials of the present invention was caused by single-crystalization.
Since no impurity is doped for trapping holes in the phosphorescent materials of the present invention, it is considered that the afterglow property of phosphorescent materials of the present invention is due to a hole trapped in the host single crystal itself via the hole-lattice interaction by d - p hybrid orbital of the hybridized 3d orbital of scandium and 2p orbital of oxygen.

### [Example 13]

### Explanation is next made of thermal resistance of the phosphorescent material of the present invention.

The disc-shaped sample of thickness about 2 mm produced from a Sc₂O₃ single crystal doped with Tb by 0.1% produced in Example 2 by the method shown in Example 10 was heated in an electric furnace at 1000 °C in atmosphere for 24 hours and was irradiated with ultraviolet light of wavelength 254 nm after cooled down to room temperature. The afterglow property was observed, but there was no change compared with the afterglow property before thermal treatment.
It is seen from this fact that the phosphorescent material of the present invention has the thermal resistance of at least 1000°C or higher.

### [Example 14]

### Explanation is made of the crystal structure of the phosphorescent material of the present invention.

The Sc₂O₃ single crystal sample was ground in an agar mortar, and crystal structure analysis was conducted by powder X ray method. It was confirmed from its X ray diffraction pattern that the sample belongs to the cubic crystal, and has a c rare earth structure. The Sc₂O₃ single crystal sample doped with Tb by 3% was also analyzed, and it was confirmed that it likewise belongs to the cubic crystal, and has the c rare earth structure.

### [Example 15]

### Explanation is made that the phosphorescent material of the present invention does not show double refraction.

The Sc₂O₃ single crystal sample and the Sc₂O₃ single crystal sample doped with Tb by 3% were processed to form disc-shaped samples by the method described in Example 10, and their both faces were polished with aluminum oxide abrasive to transmit light.
Light was illuminated in the vertical direction to the disc face of these samples after polishing, and the polarization property of the transmitted light was observed by polarizing microscope. It was confirmed that, in crossed Nicol arrangement (arrangement in which the input light was linear polarized light by a polarizer and the direction of the polarizer on the transmitted side was perpendicular to it), the transmitted light disappeared completely.
It is seen from this result that the phosphorescent material of the present invention does not show the double refraction.

### Industrial Applicability

As is understood from explanation above, since the afterglow of the phosphorescent material of the present invention has the wavelength based on f- f transition of rare earth ions and the narrow spectrum width, the afterglow wavelength of high color purity can be obtained. Since the host crystal of the phosphorescent material of the present invention is scandium oxide single crystal having melting point of 2485°C, its moisture and thermal resistances are high, and consequently it can be used under high temperature and high moisture environment. Since the host crystal of the phosphorescent material of the present invention has the crystal structure belonging to the cubic system, there is no double refraction, and the display is easily visible when the phosphorescent display device is made from it.
Therefore, if used for signs at emergency exits of a building or for evacuation guide in case of disaster, the display is easily visible and the reliance is high. Further, if rare earth elements are properly chosen so as to produce the phosphorescent materials having respective afterglows of three primary colors, and are mixed, then since color purities of respective afterglows are high, the three primary colors afterglow display apparatus is possible and applicable to craft, fiber, or others.

## Claims

1. A phosphorescent material comprising a single crystal made of scandium oxide and a rare earth element substituting scandium of said single crystal, **characterized in that**;
by irradiating ultraviolet light of energy lower than the band gap energy of said single crystal of scandium oxide, an afterglow is generated which has wavelength and spectrum width based on f - f optical transition of said rare earth element.

2. The phosphorescent material as set forth in claim 1, **characterized in that** said afterglow is generated by a hole formed by said ultraviolet light irradiation being trapped in said single crystal lattice made of scandium oxide.

3. The phosphorescent material as set forth in claim 1, **characterized in that** said rare earth element is terbium, and said ultraviolet light is that of the energy corresponding to the energy gap between 5d orbital and 4f ground orbital of terbium trivalent ion.

4. The phosphorescent material as set forth in claim 1, **characterized in that** said rare earth element is europium, and said ultraviolet light is that of the energy corresponding to the energy gap between 4f excited orbital of europium trivalent ion and 2p orbital of oxygen of said scandium oxide single crystal.

5. The phosphorescent material as set forth in any of claims 1 to 4, **characterized in that** it has thermal resistance of 1000°C or higher.

6. The phosphorescent material as set forth in any of claims 1 to 4, **characterized in that** it has no optical anisotropy.

7. A process for producing the phosphorescent material as set forth in any of claims 1 to 4, comprising
a step of mixing a rare earth element powder into a feed powder of scandium oxide,
a step of producing a feed rod by applying hydrostatic pressure to said mixed powder, and
a step of making a single crystal from said feed rod using a floating zone crystal growth method.

8. A phosphorescent display device, **characterized in that** the phosphorescent material as set forth in any of claims 1 to 4 is used.
